**Europäisches Patentamt**

**European Patent Office**

**Office européen des brevets**

(19)

(11) Numéro de publication : **0 315 631 B1**

# FASCICULE DE BREVET EUROPEEN

(12)

(45) Date de publication du fascicule du brevet :
**16.10.91 Bulletin 91/42**

(51) Int. Cl.$^5$ : **G01R 33/58, G01R 33/24**

(21) Numéro de dépôt : **87904274.5**

(22) Date de dépôt : **02.07.87**

(86) Numéro de dépôt international :
**PCT/FR87/00259**

(87) Numéro de publication internationale :
**WO 88/00340 14.01.88 Gazette 88/02**

(54) **FANTOME DE MACHINE DE RMN ET PROCEDE DE MESURE DES CARACTERISTIQUES D'UN CHAMP MAGNETIQUE UTILISANT UN TEL FANTOME.**

(30) Priorité : **08.07.86 FR 8609894**

(43) Date de publication de la demande :
**17.05.89 Bulletin 89/20**

(45) Mention de la délivrance du brevet :
**16.10.91 Bulletin 91/42**

(84) Etats contractants désignés :
**DE GB IT NL**

(56) Documents cités :
**EP-A- 0 133 722
FR-A- 2 567 648
US-A- 4 585 992
S.R. Thomas et R.L. Dixon : "NMR in medicine : The instrumentation and clinical applications", American Institute of Physics, Inc. New York, US, 1986, Proceedings of an AAPM Summer school, Portland, US, 4-9 août 1985, R.R. Price et al. "Concepts of quality assurance and phantom design for NMR systems",pages 415-444, see chapters: "Spatial resolution", "Spatial linearity", figure 13.**

(56) Documents cités :
**Patent abstracts of Japan, vol. 9, n 109 (P-355)(1982) 14 May 1985, JP-A-59230149 (Hitachi Seisakusho K.K.) 24 December 1984.
Patent abstracts of Japan, vol. 10, n 160 (P 465)(2216) 7 June 1986, JP-A-6113143 (Hitachi Seisakusho K.K.), 29 January 1986.
IEEE Transactions on Medical imaging, vol. 4, December 1985, (New York, US), K. Sekihara et al. "NMR imaging for magnets with large nonuniformities", pages 193-199, see chapter II A.B.C.**

(73) Titulaire : **GENERAL ELECTRIC CGR S.A.
100, rue Camille-Desmoulins
F-92130 Issy les Moulineaux (FR)**

(72) Inventeur : **LE ROUX, Patrick
42, rue Chaligny
F-75012 Paris (FR)**
Inventeur : **MALGOUYRES, Agnès
17, rue du Trésor
F-91120 Palaiseau (FR)**
Inventeur : **BOSSAERT, Jean
14, rue des Jardins
F-78660 Ablis (FR)**

(74) Mandataire : **Schmit, Christian Norbert Marie et al
Cabinet Ballot-Schmit 7, rue Le Sueur
F-75116 Paris (FR)**

## Description

La présente invention a pour objet un fantôme de machine de résonance magnétique nucléaire (RMN) et un procédé de mesure des caractéristiques d'un champ magnétique utilisant un tel fantôme. Elle trouve plus particulièrement son utilisation dans le domaine médical où de telles machines sont utilisées pour aider au diagnostic chez l'homme.

Une machine de RMN comporte essentiellement des moyens pour produire un champ magnétique orientateur constant intense et homogène dans une zone d'intérêt. Un corps à examiner est placé dans cette zone et les moments magnétiques des noyaux des particules de ce corps tendent à s'aligner avec ce champ orientateur. Dans ces conditions le corps est ultérieurement soumis à une excitation radiofréquence qui fait basculer l'orientation des moments magnétiques. Lorsque l'excitation cesse, les moments magnétiques se réalignent avec le champ constant en restituant l'énergie reçue pendant l'excitation. Le signal de restitution est capté et est traité pour révéler les structures des parties internes du corps sous examen. La réponse du corps est une réponse en volume : toutes les particules soumises à l'examen emettent leur signal de restitution en même temps. De manière à différencier les signaux relatifs à différentes parties du corps il est prévu que l'excitation soit appliquée en présence d'un codage de l'espace. Ce codage comporte l'administration de champs constants supplémentaires, différents en différents lieux de l'espace. En effet le phénomène de résonance, en chaque endroit, est fonction de l'amplitude du champ constant et des caractérisitiques des particules examinées. Dans le domaine médical les particules que l'on cherche à faire résonner sont les atomes d'hydrogène contenus dans l'eau ainsi que dans tous corps organiques, et dont la concentration varie d'un tissu à l'autre.

Le principe même des procédés d'imageries nécessite que le champ orientateur et le codage de l'espace soient rigoureux. En particulier si le champ orientateur n'est pas homogène, s'il est différent en différents endroits de la zone d'intérêt, il introduit des codages parasites qui faussent l'image. De même les champs supplémentaires codeurs doivent être connus avec précision : ces champs codeurs évoluent souvent d'une manière linéaire selon un axe. Leur variation linéaire est assimilable à un gradient : d'où leur nom. Les gradients de champ doivent être particulièrement linéaires. Toute distorsion de leur linéarité introduit également des codages parasites qui faussent l'image. Dans un premier temps on a considéré que les parasites de codage affectant le champ orientateur très puissant étaient prépondérants. Aussi les machines de l'état de la technique comportent elles des moyens de correction de l'homogénéité du champ, sur lesquels on agit de manière à rendre ce champ homogène. Ces moyens de correction (dits shims dans la littérature anglo-saxonne) sont réglables et leur valeur est ajustée sur site en fonction d'une inhomogénéité constatée.

Dans l'état de la technique il est connu de mesurer l'inhomogénéité du champ orientateur dans sa zone d'interêt en déplaçant, de point en point dans cette zone, une sonde de mesure du champ magnétique. Pratiquement, dans une zone d'intérêt cylindrique dont le diamètre vaut légèrement plus que 50cm et dont la hauteur est du même ordre, il est connu, pour connaitre l'homogénéité du champ avec suffisamment de précision, d'effectuer des mesures de sa valeur en un nombre de points de l'ordre d'une ou plusieurs centaines. En fonction de l'inhomogénéité constatée on agit selon des procédés connus sur les moyens de correction d'homogénéité. Pour plus de précision, ou tout simplement pour vérifier, il peut être utile de réitérer, après une première correction, l'opération de mesure de l'homogénéité du champ. Plus généralement, étant donné que le champ intense est soumis à des dérives, il peut s'avérer utile de rétablir souvent son homogénéité, par exemple une fois par jour. Pour que les mesures soient effectuées dans de bonnes conditions il est nécessaire que la sonde, à chaque opération de mesure, soit replacée en des mêmes endroits de la zone d'intérêt. Un appareillage mécanique est alors nécessaire pour atteindre ce but. Comme le déplacement de la sonde de place en place doit être effectué avec précision, il en résulte que la mesure est longue. Elle dure plusieurs heures. Ceci en interdit l'exécution trop fréquente rendue pourtant nécessaire par les dérives inévitables du champ orientateur.

Sachant que dans leur configuration les appareils de RMN ont été prévus pour délivrer des images on a tenté d'introduire un fantôme homogène dans la zone d'intérêt et d'en faire l'image. L'intention était de révéler, par distorsion de cette image qui théoriquement devait être homogène, les inhomogénéités du champ. Cette technique s'est malheureusement heurtée à un inconvénient insurmontable : l'image est représentative des inhomogénéités du champ orientateur d'une part et des inhomogénéités des gradients de champ, qui ont justement servi à produire l'image, d'autre part. En conséquence l'utilisation de l'image d'un tel fantôme se révéle inexploitable car elle ne constate que le défaut cumulé des deux types d'inhomogénéité, sans permettre d'affecter la part qui revient à chacun d'eux, de manière à autoriser leur correction respective.

Dans l'invention on remédie à cet inconvénient en réalisant un fantôme qui, tout en étant homogène, est discret. Ceci signifie que le matériau homogène du fantôme qui va servir à faire l'image est confiné en des endroits précis. Dans un exemple préféré ces endroits précis sont même répartis matriciellement. Dans ces conditions l'utilisation d'une méthode d'imagerie particulière, connue par ailleurs, est envisageable. La performance de cette méthode est alors judicieusement exploitée et permet, en combinaison avec la repartition matricielle, d'atteindre les buts visés : connaissance du champ en de nombreux points, et rapidité d'exécution des mesures. On montrera dans la présente description qu'il est possible de différencier les parts d'inhomogénéité relatives à chacun des moyens mis en oeuvre : le champ orientateur d'une part, les gradients de champ d'autre part. En résumé on peut dire qu'on connait l'image à produire puisqu'on sait comment on a fabriqué le fantôme. Par conséquent on sait où devraient se trouver dans cette image les points représentatifs des lieux discrets où se trouve le matériau résonnant. Si l'image est distordue, par exemple si les lieux ne sont pas alignés rectilignement mais plutôt selon une courbe, on peut en déduire que la distorsion est due au gradient. En outre, dans la pratique, le déplacement dans l'image rendue de l'image d'un élément discret du matériau résonnant par rapport à son image attendue est tel qu'on sait immédiatement quel est le déplacement subit par ce point d'image. On ne peut le confondre avec un autre. On peut donc mesurer et connaitre la distorsion des gradients. D'autre part le paramètre contraste de luminosité dans l'image est représentatif à lui seul de l'inhomogénéité du champ orientateur. On peut donc aussi la connaitre simplement. Il est classique ensuite de déduire les corrections à appliquer au champ orientateur. La fréquence de répetition des opérations de correction d'homogénéité du champ est en outre primordiale. Il importe alors d'aboutir au résultat rapidement. Dans l'invention on montre que la disposition matricielle des lieux discrets permet, du fait de la périodicité de répartition, d'obtenir une résolution de définition des inhomogénéités la plus fine possible pour une durée de mesure donnée la plus faible possible.

Un article de R.R. PRICE et al "Concepts of quality assurance and phantom design for NMR systems" paru dans "NMR in medicine: The instrumentation and clinical application", American Institute of Physics, Inc. NEW YORK, U.S., 1986, Proceedings of an AARM summer school, PORTLAND, U.S., 4-9 août 1985, présente une répartition matricielle des positions des échantillons du fantôme. Cependant, du fait de l'orientation quelconque de ce fantôme dans la machine de RMN, le procédé décrit ne conduit ni à une meilleure vitesse de calcul de correction, ni à la meilleure résolution de cette correction. En définissant une meilleure orientation de ce fantôme, l'invention contribue à améliorer ces résultats.

La présente invention a pour objet un fantôme pour machine de RMN selon la revendication 1.

L'invention sera mieux comprise à la lecture de la description qui suit et l'examen des figures qui l'accompagnent. Celles ci ne sont qu'indicatives et nullement limitatives de l'invention. Sur les figures les mêmes repères se rapportent à des mêmes éléments. Les figures montrent :

- figure 1 : une machine de RMN munie d'un fantôme selon l'invention;
- figure 2 : une éprouvette de confinement du matériau résonnant utilisée dans le fantôme;
- figure 3a à figure 3e : des diagrammes temporels de signaux d'excitation et de mesure utilisés dans le procédé de l'invention;
- figure 4 : la représentation des images dune des coupes du fantôme;
- figure 5 : la mise en évidence de la caractéristique d'inhomogénéité du champ orientateur à l'endroit d'un des lieux discrets selon l'invention.

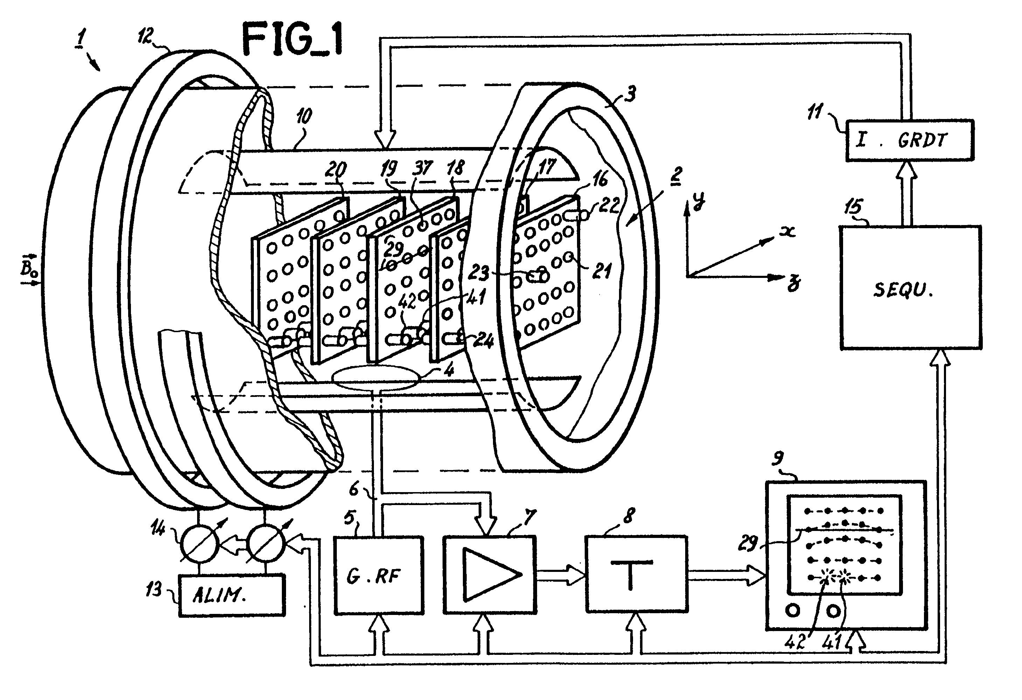

La figure 1 montre une machine de RMN 1 munie du fantôme 2 selon l'invention. La machine 1 comporte essentiellement des moyens 3 pour produire un champ magnétique intense et homogène $B_0$ dans sa zone d'interêt. Ici l'aimant 3 est symbolisé par un tube cylindrique, la zone d'intérêt est intérieure à ce tube, le fantôme est placé dans cette zone d'intérêt. La machine comporte encore une antenne radiofréquence 4 reliée à un générateur 5 pour produire une excitation radiofréquence du corps placé sous l'influence du champ $B_0$. Lorsque l'excitation cesse l'antenne 4 sert à prélever le signal de désexcitation émis par le corps sous examen. Ce signal est acheminé par l'intermédiaire d'un duplexeur 6 vers des moyens de réception 7. Le signal reçu est alors traité par des moyens de traitement 8 pour produire des images représentatives de la distribution du matériau résonnant dans le corps. Ces images peuvent être visualisées sur un dispositif de visualisation 9.

On a également représenté des bobines de gradient 10 alimentées par un générateur 11 d'impulsions de gradient. Les impulsions servent à coder l'espace en ajoutant au champ orientateur des champs supplémentaires dont la valeur évolue linéairement (gradient) selon trois axes orthogonaux. On a coutume de repérer ces trois axes, x,y,z, en orientant le dernier d'entre eux parallèlement au champ $B_0$. Ceci n'est pas une obligation mais correspond à une coutume commune à tous les hommes du métier de la RMN. La machine de RMN 1 comporte en outre des moyens de correction tels que 12, alimentés par une alimentation 13, et dont le pouvoir de correction est réglable au moyen de commandes 14. L'ensemble de tout ces moyens est sous la dépendance d'un séquenceur 15 qui peut être affecté à des multiples tâches. En particulier le séquenceur 15 sert à mettre en oeuvre les programmes de déroulement des séquences d'excitation - mesure. Il sert en outre à piloter les moyens de traitement pour élaborer les images à partir des mesures. Il peut enfin servir à commander le réglage de l'homogénéité du champ en agissant sur les commandes 14.

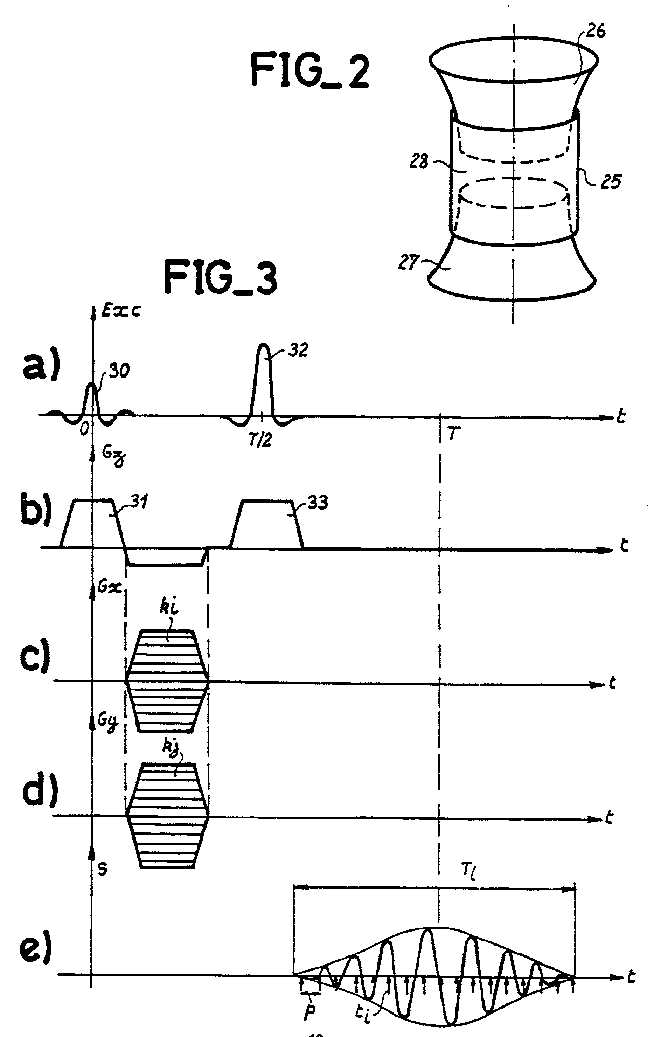

Le fantôme discret de l'invention comporte, dans un exemple préféré, un ensemble de plaques 16 à 20, parallèles les unes aux autres et alignées les unes avec les autres le long de l'axe z. Les différentes plaques du fantôme sont reliées par des entretoises non représentées ou par tout autre moyen mécanique de maintien. Le fantôme 2 est relativement rigide pour permettre sa manipulation sans inconvénient. Chaque plaque est munie d'un ensemble de trous tels que 21 répartis matriciellement et régulièrement selon deux axes orthogonaux à l'axe d'alignement. Ces deux axes orthogonaux sont orientés, en orientant le fantôme, pour être parallèles aux axes principaux d'imagerie de la machine 1 (axes des gradients 10). Dans chacun des trous est insérée une éprouvette telle que 22,23 ou 24. Ces éprouvettes sont par ailleurs représentées sur la figure 2. Chaque éprouvette comporte un tube 25 obturé de part et d'autre par un bouchon 26 ou 27. Chaque éprouvette est remplie d'un matériau résonnant 28 : dans la pratique ce matériau résonnant peut être tout simplement de l'eau. Le matériau des plaques, des entretoises, des éprouvettes qui sont enfichées, et des bouchons des éprouvettes est un matériau de préférence non résonnant aux fréquences utiles de l'expérience, ou du moins peu résonnants : il comporte peu d'hydrogène. Dans un exemple le corps du fantôme est réalisé en PVC.

Tous les trous de chaque plaque étant munis d'une éprouvette, l'image d'une plaque, par exemple la plaque 18, doit apparaitre sur l'écran du dispositif 9 comme un arrangement de points régulièrement répartis. Le rappel 29 de l'alignement des points de la plaque 18 montre sur l'écran du dispositif 9 l'influence des gradients de codage de l'espace. Les différents points image ne sont plus alignés selon une droite. Il est cependant tout à fait possible de repérer le lieu de leur image mesurée et d'affecter à chacun d'eux la position théorique qu'il aurait dû occuper. L'ecart entre la position théorique et la position mesurée indique le défaut de linéarité des gradients de codage. De ce défaut qui peut être mesuré on peut déduire quantitativement le défaut des gradients. On peut éventuellement modifier ces gradients à partir de cette information. On peut aussi, en en tenant compte, modifier les images produites par la machine.

A l'examen des figures 3 à 5 on va expliquer comment le fantôme permet également de mesurer l'inhomogénéité du champ orientateur $B_0$. Dans l'invention, le relevé du signal de restitution est effectué à la fin de chacune des séquences d'excitation d'un ensemble de séquences qui sont du type de celles mises en oeuvre (mais dans un autre but) dans le brevet américain 4 553 096 publié le 12 novembre 1985. La figure 3 de la présente description rappelle l'organisation de principe de ces séquences. A chaque séquence de l'ensemble des séquences, à la date t = 0, une impulsion 30 d'excitation radiofréquence à 90° est émise en présence d'une impulsion 31 de gradient de champ de sélection $G_z$. On soumet ainsi le matériau résonnant contenu dans les éprouvettes d'une seule des plaques (par exemple la plaque 18) à l'excitation. Au bout d'une durée T/2 une deuxième excitation radiofréquence 32 à 180° est émise également en présence d'une deuxième impulsion 33 de gradient de champ de sélection. L'excitation ainsi construite est une excitation dite à écho de spin. Elle permet la mesure du signal de restitution autour d'une date T (et avec une durée $T_l$) assez éloignée de la date d'émission de l'impulsion d'excitation 30.

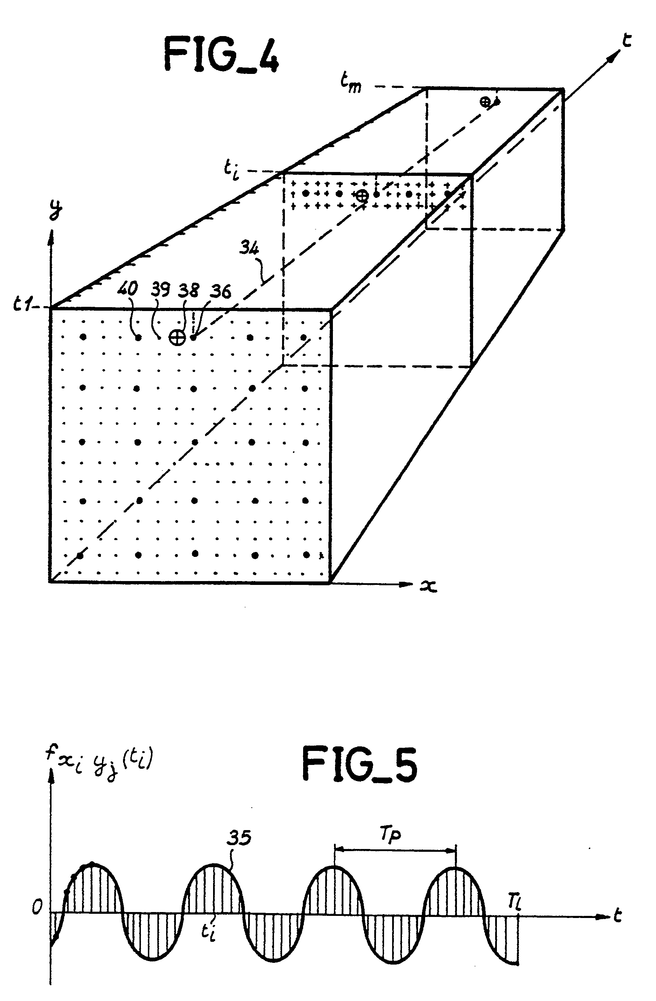

La durée qui sépare ces deux dates est mise à profit pour appliquer des gradients de champ selon les deux autres axes, $G_x$ et $G_y$, avec des valeurs variables d'une séquence à l'autre. Par exemple, au cours d'une première série de séquences, l'impulsion de gradient $G_y$ est toujours la même, tandis que d'une séquence à l'autre de cette série l'impulsion de gradient $G_x$ (proportionnelle à $k_i$) varie. Puis au cours d'une série suivante de séquences, le gradient $G_y$ prend une autre valeur (proportionnelle à $k_j$) tandis que le gradient $G_x$ prend encore une fois d'une séquence à l'autre de cette série, des mêmes valeurs différentes que pour les séquences de la série précédente de séquences. Il est important de remarquer que, contrairement aux méthodes classiques d'imagerie, il n'y a pas ici d'application de gradient de lecture pendant la mesure-lecture ($T_l$) du signal de restitution. Cette particularité sera justifiée par l'explication relative à la figure 5. Si $n$ est le nombre des différentes valeurs possibles de $k_i$ et/ou de $k_j$, on disposera d'un ensemble de n x n mesures. Au cours de chacune de ces mesures on échantillonne le signal de restitution à des dates séparées les unes des autres par une durée $p$ (fig.3e). On dispose alors d'un grand nombre d'échantillons dont les valeurs $v$ sont fonction de la date de l'échantillon ($t_i$) et de la caractéristique de la séquence qui a provoqué son apparition ($k_i$ et $k_j$). De cet ensemble d'échantillons $v(t_i, k_i, k_j)$ il est possible d'obtenir par double transformée de Fourier, un ensemble de valeurs $f(t_i, x, y,)$ représentatives, à $t_i$ donné, de la valeur de l'image en x et y d'une coupe étudiée (plaque 18 et figure 4). L'absence du gradient de lecture, qui retire à cette méthode d'imagerie le bénéfice de la différenciation en fréquence que ce gradient procure, est compensée par le double codage en $x$ et en $y$ au moment de l'excitation. La reconstruction d'image, par transformée de Fourier à deux dimensions, est cependant du même type que pour les méthodes 2 DFT.

Comme on a prélevé $m$ échantillons pendant la durée $T_l$ on peut alors représenter m images correspondant chacune à une des dates d'échantillonnage du signal mesuré. Dans la figure 4 on s'aperçoit que, pour chacune des $m$ images, l'image réelle montrée par une croix cerclée, d'une des éprouvettes de matériau résonnant ne se trouve pas à la place où théoriquement elle aurait dû se trouver. Cette place théorique correspond à l'alignement 34. Sous une certaine condition que l'on évoquera plus loin elle en est décalée d'une valeur représentative de la distorsion des gradients de codage de l'espace à l'endroit de cette éprouvette.

Sur la figure 5 on a reporté, pour une localisation $x_i, y_j$ de chacune des images de la figure 4, la valeur de $f$ en fonction de la date $t_i$ à laquelle elle a été calculée. Ces valeurs suivent une courbe 35 que l'on peut dessiner. La signification de cette courbe est la suivante. Lors de la réception du signal de restitution, il est connu de démoduler ce signal par un signal à une fréquence $f_0$ égale à la fréquence théorique à laquelle aurait dû résonner le matériau si, à l'endroit ou ce matériau se trouvait, le champ intense avait eu la valeur prescrite : $B_0$. Si tel est le cas, le signal de restitution, relatif au point considéré correspond à un mouvement de précession à $f_0$ du moment magnétique, et sa démodulation suivie du traitement par double transformée de Fourier donne une valeur $f$ constante ou nulle. Par contre si à l'endroit de l'éprouvette considérée une légère inhomogénéité du champ $B_0$ existe, $\Delta B_0$, le signal restitué vibre à une fréquence décalée de $f_0$ d'une valeur $\Delta f_0$ proportionnelle à l'inhomogénéité en question. La courbe 35 correspond à un tel cas. En effet la valeur de $f$ évolue dans le temps. Elle montre un battement en fréquence par rapport à la fréquence de démodulation. Du diagramme temporel de la figure 5 il est possible de déduire un $\Delta f_0$ égal à l'inverse de la période $T_p$ du battement cyclique de $f(t_i)$. On peut éviter d'avoir à résoudre graphiquement le problème de trouver $T_p$ en effectuant une troisième transformée de Fourier, de $f(t_i)$, qui donne immédiatement le décalage $\Delta f_0$ de la fréquence de précession. En chaque point, point 36 de l'image théorique correspondant à un point réel 37 dans la plaque examinée (voir figure 1), on connaît alors la valeur de l'inhomogénéité $\Delta B_0$ ; bien que celle ci ait été révélée comme se trouvant en un endroit 38 décalé de sa position vraie. Avec ces informations on peut, après traitement de type connu, en déduire les commandes à appliquer aux organes de commande 14. D'une manière préférée, ce travail est effectué automatiquement par le séquenceur 15. On remarque cependant que le battement n'est mesurable que parce qu'il n'y a pas de gradient de lecture pendant la mesure.

Du diagramme de la figure 5 on tire l'enseignement que la plus grande inhomogénéité mesurable (donc la plus faible période $T_p$ détectable correspond selon Shannon à un décalage maximum en fréquence égal à $1/2 p = m/2T_l$. De même la plus faible fréquence de battement mesurable est telle que $T_p = T_l$. Autrement dit, la dynamique de révélation des inhomogénéités est contenue dans une plage donnée. Dans un exemple où $f_0$ est de l'ordre de 20 MHz, où $T_l$ vaut 50 millisecondes, et où $m$ vaut 128 (128 échantillons pendant $T_l$) on peut détecter au plus des battements de 1/50 millisecondes = 20 Hz. Cette fréquence de battement représente une partie par million de la fréquence de résonance $f_0$. Elle correspond donc à une inhomogénéité d'une partie par million (ppm) de la valeur du champ constant homogène. Pour la valeur de $m$ donnée on ne peut alors, dans les mêmes conditions, ne montrer des inhomogénéités qu'inférieures à m/2 ppm soit 64 ppm. Si on veut voir avec le procédé de l'invention des inhomogénéités plus fortes que cette valeur il convient soit d'augmenter m à $T_l$ constant, soit de réduire $T_l$ à $m$ constant.

L'augmentation de $m$ peut provoquer des difficultés de traitement. En effet les calculs de transformée de Fourier risquent de devenir trop longs si $m$ est supérieur à 256. Par contre la technologie permet de choisir une durée de mesure $T_l$ plus faible tout en prenant le même nombre d'échantillons. Par exemple on peut retenir $T_l$ égal à 25 millisecondes et $m$ = 256. Ceci permet de montrer des inhomogénéités jusqu'à 1024 ppm. Les dérives journalières dont il est question sont inférieures en général à cette valeur. Autrement dit pour une même tranche de la zone, celle où est située la plaque 18, on peut acquérir la première fois les résultats en faisant deux séries d'expérimentations avec des fréquences d'échantillonnage et des durées d'échantillonnage différentes. Puis, pour les corrections journalières, il peut suffire de faire une seule acquisition.

Par ailleurs tout le travail entrepris pour une tranche de la zone d'intérêt, à l'endroit de la plaque 18 est évidemment entrepris pour les autres tranches de la zone d'intérêt, où se trouvent les autres plaques du fantôme. A cet effet il suffit simplement de changer la valeur de la fréquence d'excitation au moment de l'excitation. Cette technique est connue dans les procédés d'imagerie RMN multicoupes. Cependant, autant les inhomogénéités des gradients en $x$ et en $y$ étaient facilement perceptibles, autant les inhomogénéités du gradient $z$ ont des effets qui passent inaperçus. En effet les défauts du gradient $z$ provoquent, pour certains points de la coupe un décalage avant ou arrière de l'image. Autrement dit pour ces points leur image est dans un plan decalé de celui qui représente l'image de la plaque sélectionnée : ils disparaissent de cette image. Ainsi les images 41 et 42 des éprouvettes 41 et 42 de la plaque 18 ne sont pas présentes dans son image. Pour les retrouver il suffit de sélectionner des plans de coupe en amont et en aval de la plaque 18. On aurait pu s'attendre, si le gradient $z$ avait été linéaire, à ne pas avoir a donner d'images de parties de l'espace où il n'y a rien : dans l'invention des coupes supplémentaires montrent les images manquantes.

Dans un exemple la conduite des mesures, et le traitement des signaux mesurés pour élaborer les signaux de battements (figure 5) relatifs à chaque lieu d'une plaque durent environ 4 mn. Pour 5 plaques la durée d'expérimentation est aussi de 4 mn compte tenu d'un traitement en entrelacement. Du fait de l'inhomogénéité du gradient $z$, le fait de devoir tripler le nombre des coupes peut conduire à une durée de 12 mn. Ces durées sont à rapprocher de celle évoquées dans l'état de la technique cité. Elles sont bien plus courtes. Par ailleurs la simplicité de la mise en place du fantôme à l'intérieur de la zone d'intérêt de l'aimant n'a rien de comparable avec la complexité de la manipulation de l'appareil porte-sonde de l'état de la technique cité.

Le nombre des séquences de chaque série, et la durée de 'traitement mathématique nécessaire pour élaborer les images de la figure 4, relatives aux dates des différents échantillons, sont d'autant plus grands que la résolution désirée de ces images est grande également. On a trouvé qu'il était suffisant de représenter les images, aux dates de chacun des échantillons, avec une résolution dont le pas est seulement trois fois plus fin que le pas de répartition du matériau résonnant dans le fantôme. En effet du fait des inhomogénéités de gradient, qui sont faibles, la localisation "mesurée" est voisine de la localisation théorique à atteindre. Le rapport trois est tel qu'il permet d'accepter une image en un point 38 d'un lieu théorique en 36, et d'accepter une image en un point 39 d'un lieu théorique adjacent en 40, sans avoir le risque que les images mesurées en 38 et 39 puissent se confondre. Ceci pourrait par contre être le cas si la résolution de la représentation était égale à la répartition des éprouvettes dans les plaques du fantôme. Ou même si elle n'était égale qu'au double de cette distribution.

En pratique chaque plaque comporte 25 éprouvettes en une matrice de 5 par 5. Il suffit alors, dans l'image représentée sur le dispositif 9, d'avoir une résolution par 16 ($3 \times 5 \simeq 16$) selon chaque axe pour désigner, sans risque de mélange, les images mesurées des points réels. La division en un quadrillage de 16 par 16 de l'écran 9 conduit automatiquement à ne retenir que 16 valeurs pour $k_i$ et que 16 pour $k_j$. Ceci permet de réduire au mieux la durée de l'expérimentation en limitant le nombre des séquences dans chaque série de séquences. On comprend alors que toute repartition des éprouvettes, non matricielle, non régulière, et non orientée selon les axes d'imagerie ne permet pas d'atteindre ce résultat. En effet si la répartition n'est pas régulière il faut adapter cette résolution aux cas les plus défavorables, c'est à dire aux éprouvettes les plus près les unes des autres. Par exemple avec une répartition cylindrique, des éprouvettes intérieures, plus proches les unes des autres que des éprouvettes périphériques, imposent une résolution plus fine que celle nécessaire pour différencier les éprouvettes extérieures. En outre les gradients étant orientés selon des axes prédeterminés $(x,y,z)$, toute répartition en oblique des éprouvettes par rapport à ces axes réduit la différenciation en fonction du cosinus de l'angle d'inclinaison. Il faut alors augmenter d'autant la résolution de l'image (et donc sa durée de reconstruction) pour séparer les différentes contributions.

## Revendications

1. Machine d'imagerie par RMN munie d'un fantôme comportant des moyens (16-28) pour confiner un matériau résonnant en des lieux discrets, ces lieux étant distribués matriciellement selon des directions (X,Y,Z) orthogonales entre elles et ces lieux étant régulièrement espacés les uns des autres en un réseau maillé, cette machine comportant des axes principaux d'imagerie définis par des gradients de cette machine, caractérisée en ce qu'elle comporte des moyens pour que les directions orthogonales du fantôme soient parallèles à ces axes principaux.

2. Machine selon la revendication 1 caractérisée en ce que les moyens pour confiner comportent au moins une plaque (18), en matériau non résonnant à une fréquence utile, percée de trous (21) à l'endroit des lieux à aménager, et des éprouvettes fermées (Fig.2), en matériau non résonnant à la fréquence utile, et placées dans les trous.

3. Machine selon la revendication 2, caractérisé en ce que le fantôme comporte plusieurs plaques (16,20) alignées et espacées les unes par rapport aux autres selon une direction (Z) perpendiculaire au plan de ces plaques.

4. Procédé de mesure des caractéristiques d'un champ magnétique, notamment son homogénéité, comportant les étapes suivantes :
   – la réalisation d'un fantôme (16-28) muni de moyens pour confiner un matériau résonnant en des lieux discrets, distribués matriciellement selon des directions orthogonales entre elles,
   – la mise en place de ce fantôme à l'endroit du champ à connaître,
   – la soumission, à cet endroit, de ce fantôme à des séquences d'excitation magnétique (4,5) en présence de séquences de gradients (10,11) de champ magnétique, ces gradients définissant des axes principaux d'imagerie,
   – la mesure des signaux de désexcitation émis par le matériau résonnant quand l'excitation cesse et en l'absence de séquences de gradients,
   – et le traitement des signaux de désexcitation pour en extraire une ou des images représentatives du champ à connaître.
   caractérisé en ce que
   – on place le fantôme de telle façon que les directions du fantôme soient parallèles aux axes principaux d'imagerie.

5. Procédé selon la revendication 4 caractérisé en ce que les séquences d'excitation sont en nombre suffisant pour que la résolution des images représentatives soit supérieure au double de celle correspondant à la distribution discrète du matériau dans le fantôme.

6. Procédé selon la revendication 5 caractérisé en ce que la résolution est sensiblement égale au triple de la distribution de matériau.

7. Procédé selon l'une quelconque des revendications 4 à 6 caractérisé en ce qu'on réitère les étapes d'excitation-mesure, en modifiant pour cette réitération la durée de mesure des signaux de désexcitation et/ou un nombre d'échantillons prélevés pendant cette mesure, pour affiner la connaissance des caractéristiques du champ à connaître.

8. Procédé selon l'une quelconque des revendications 4 à 7 caractérisé en ce que le traitement comporte des calculs de transformée de Fourier à 3 dimensions pour évaluer des inhomogénéités de champ.

9. Procédé selon l'une quelconques des revendications 4 à 8 caractérisé en ce qu'on réitère les étapes d'excitation-mesure en modifiant pour cette réitération les caractéristiques des séquences d'excitation pour explorer les tranches du champ adjacentes à celles ou se trouvent les lieux discrets, en une expérimentation de type multicoupe.

10. Procédé selon l'une quelconques des revendications 4 à 9 caractérisé en ce que les séquences de gradients correspondent à une série $(k_j)$ de séries $(k_i)$ de codages en phase des moments magnétiques du matériau.

11. Procédé selon la revendication 10 caractérisé en ce que les séquences de gradient comportent une impulsion d'un gradient de sélection d'un des plans de distribution des lieux discrets du fantôme.

## Patentansprüche

1. Gerät zur Bilderzeugung mittels NMR, das mit einem Phantom versehen ist, das Mittel (16-28) aufweist, um ein Resonanzmaterial auf diskrete Orte einzugrenzen, die matrixförmig in zueinander senkrechten Richtungen (X, Y, Z) verteilt sind und die in einem Maschennetz einen regelmäßigen gegenseitigen Abstand besitzen, wobei dieses Gerät Hauptachsen aufweist, die durch die Gradienten dieses Geräts definiert werden, dadurch gekennzeichnet, daß es Mittel aufweist, damit die senkrechten Richtungen des Phantoms zu diesen Hauptachsen parallel sind.

2. Gerät gemäß Anspruch 1, dadurch gekennzeichnet, daß die Mittel zum Eingrenzen wenigstens eine Platte (18) aus einem bei einer verwendeten Frequenz keine Resonanz zeigenden Material, die an den Stellen der einzurichtenden Orte von Löchern (21) durchsetzt ist, und in den Löchern angeordnete, verschlossene Probekörper (Fig. 2) aus einem bei der verwendeten Frequenz keine Resonanz zeigenden Material aufweisen.

3. Gerät gemäß Anspruch 2, dadurch gekennzeichnet, daß das Phantom mehrere Platten (16, 20) aufweist, die in einer Richtung (Z) senkrecht zur Ebene dieser Platten zueinander ausgerichtet sind und sich in einem gegenseitigen Abstand befinden.

4. Verfahren zur Messung der Eigenschaften eines Magnetfeldes, insbesondere dessen Homogenität, mit den folgenden Schritten:
– Herstellen eines Phantoms (16-28), das mit Mitteln zum Eingrenzen eines Resonanzmaterials auf diskrete Orte, die in zueinander senkrechten Richtungen matrixförmig verteilt sind, versehen ist,
– Anordnen dieses Phantoms an der Stelle des zu erkennenden Feldes,
– dieses Phantom wird an dieser Stelle einer Reihe von magnetischen Erregungen (4, 5) bei Vorliegen von Reihen von Gradienten (10, 11) des Magnetfeldes ausgesetzt, wobei diese Gradienten die Hauptachsen der Bilderzeugung definieren,
– Messen der Aberregungssignale, die von dem Resonanzmaterial ausgesandt werden, wenn die Erregung beendet ist und bei Abwesenheit der Gradientenreihen,
– und Bearbeiten der Aberregungssignale, um daraus eines oder mehrere Bilder, die das zu erkennende Feld darstellen, zu entnehmen, dadurch gekennzeichnet, daß
– das Phantom so angeordnet wird, daß die Richtungen des Phantoms parallel zu den Hauptachsen der Bilderzeugung sind.

5. Verfahren gemäß Anspruch 4, dadurch gekennzeichnet, daß die Erregungsreihen in einer ausreichenden Anzahl vorhanden sind, damit die Auflösung der dargestellten Bilder mehr als doppelt so hoch wie diejenige ist, die der diskreten Verteilung des Materials im Phantom entspricht.

6. Verfahren gemäß Anspruch 5, dadurch gekennzeichnet, daß die Auflösung im wesentlichen gleich dem Dreifachen der Verteilung des Materials ist.

7. Verfahren gemäß einem der Ansprüche 4 bis 6, dadurch gekennzeichnet, daß die Erregungs/Meß-Schritte wiederholt werden, wobei für diese Wiederholung die Dauer der Messung der Signale der Aberregung und/oder eine Anzahl von während dieser Messung genommenen Meßwerten abgewandelt werden, um die Kenntnis der Eigenschaften des zu erkennenden Feldes zu verfeinern.

8. Verfahren gemäß einem der Ansprüche 4 bis 7, dadurch gekennzeichnet, daß die Bearbeitung die Berechnung von dreidimensionalen Fourier-Transformationen umfaßt, um die Inhomogenitäten des Feldes auszuwerten.

9. Verfahren gemäß einem der Ansprüche 4 bis 8, dadurch gekennzeichnet, daß die Erregungs/Meß-Schritte wiederholt werden, wobei für diese Wiederholung die Eigenschaften der Reihen von Erregungen bei einem Mehrfachschnitt-Versuch abgewandelt werden, um die Schnittflächen des Feldes, die an diejenigen angrenzen, an denen sich die diskreten Orte befinden, zu untersuchen.

10. Verfahren gemäß einem der Ansprüche 4 bis 9, dadurch gekennzeichnet, daß die Folgen von Gradienten einer Reihe ($k_j$) von Reihen ($k_i$) von phasengleichen Kodierungen von magnetischen Momenten des Materials entsprechen.

11. Verfahren gemäß Anspruch 10, dadurch gekennzeichnet, daß die Folgen von Gradienten einen Gradientenimpuls für die Auswahl einer der Verteilungsebenen der diskreten Orte des Phantoms umfassen.

**Claims**

1. An image forming apparatus using NMR provided with a phantom comprising means (16 through 28) in order to confine a resonant material in discrete positions, said positions being distributed matrix-wise in accordance with rectangular coordinates (X, Y and Z) and said positions being regularly spaced in relation to each other in a lattice, said apparatus comprising principal imaging axes defined by gradients of the apparatus, characterized in that it comprises means to cause the rectangular coordinates of the phantom to be parallel to the said principal axes.

2. The apparatus as claimed in claim 1, characterized in that the confining means comprise at least one plate (18) of material which is non-resonant at a working frequency, and having holes (21) at the site of the positions in question, and sealed samples (figure 2) made of a material which is non-resonant at the working frequency and positioned in the holes.

3. The apparatus as claimed in claim 2, characterized in that the phantom comprises a plurality of plates (16 and 20) in alignment and spaced from each other along a coordinate (Z) perpendicular to the plane of the plates.

4. A method of measuring the characteristics of a magnetic field, more particularly with respect to its homogeneity, comprising the following stages:
   – the production of a phantom (16 through 28) provided with means in order to confine a resonant material in discrete positions distributed matrix-wise in accordance with rectangular coordinates,
   – the placing of the phantom at the site of the field to be appreciated,
   – the submission, at the said site, of the phantom to magnetic excitation sequences (4 and 5) in the presence of sequences of magnetic field gradients (10 and 11), said gradients defining principal image forming axes,
   – measuring the signal of de-excitation emitted by the resonant material when such excitation ceases and in the absence of gradient sequences,
   – and the treatment of the de-excitation signals in order to extract therefrom one or more images representative of the field to be appreciated. characterized in that the phantom is placed in such a manner that the coordinates of the phantom are parallel to the principal axes of image formation.

5. The method as claimed in claim 4, characterized in that the number of the excitation sequences is sufficient for the resolution of the representative images to be greater than twice the number corresponding to the discrete distribution of the material in the phantom.

6. A method as claimed in claim 5, characterized in that the resolution is substantially equal to three times the distribution of the material.

7. The method as claimed in any one of the preceding claims 4 through 6, characterized in that the stages of excitation and measurement are reiterated by modifying for each reiteration the duration of measurement of the de-excitation signals and/or a number of samples taken during this measurement in order to improve the knowledge of the characteristics of the field to be appreciated.

8. The method as claimed in any one of the preceding claims 4 through 7, characterized in that the treatment comprises calculations of the three dimensional Fourier transform in order to evaluate the inhomogeneities of the field to be appreciated.

9. The method as claimed in any one of the preceding claims 4 through 8, characterized in that the stages of excitation and measurement are reiterated while modifying for such reiteration the characteristics of the excitation sequences in order to investigate the slices of the field adjacent to those where the discrete positions are located, using a multi-slice type of investigation.

10. The method as claimed in any one of the preceding claims 4 through 9, characterized in that the gradient sequences correspond to a series ($k_j$) of series ($k_i$) of encodings in phase of the magnetic moments of the material.

11. The method as claimed in claim 10 characterized in that the gradient sequences comprise a gradient pulse for the selection of one of the planes of distribution of the discrete positions of the phantom.

FIG_1

EP 0 315 631 B1

FIG_2

FIG_3

a)

b)

c)

d)

e)

10

# FIG_4

# FIG_5